# EUROPÄISCHE PATENTSCHRIFT

(11) **EP 1 033 622 B1**
(45) Veröffentlichungstag und Bekanntmachung des Hinweises auf die Patenterteilung: **08.04.2009**
(21) Anmeldenummer: 00104115.1
(22) Anmeldetag: 29.02.2000
(51) Int. Cl.: G03F 1/00, B41C 1/10, B41M 5/24, G03F 7/11

(54) **Verfahren zur Herstellung von flexographischen Druckformen**
Process for the preparation of flexographic printing forms
Procédé de fabrication de plaques d'impression flexographique

(30) Priorität: 02.03.1999 DE 19909152
(43) Veröffentlichungstag der Anmeldung: 06.09.2000
(73) Patentinhaber: DU PONT DE NEMOURS (DEUTSCHLAND) GMBH, 61352 Bad Homburg (DE)
(72) Erfinder: Metzger, Bernhard, Dr., 76829 Landau (DE)
(74) Vertreter: DuPont Performance Coatings Biering/Blum/Kimpel

(56) Entgegenhaltungen:
- EP-A- 0 891 876
- WO-A-94/03838
- WO-A-94/03839
- WO-A-96/16356
- US-A- 5 534 383

## Beschreibung

Die Erfindung betrifft ein Verfahren zur Herstellung von flexographischen Druckformen, wobei ein photopolymerisierbares Aufzeichnungselement mindestens einen Schichtträger, mindestens eine photopolymerisierbare Schicht, enthaltend mindestens ein polymeres Bindemittel, mindestens eine ethylenisch ungesättigte, copolymerisierbare organische Verbindung und mindestens einen Photoinitiator oder ein Photoinitiatorsystem, und eine gegen IR-Strahlung empfindliche und gegenüber aktinischer Strahlung opake Schicht umfasst.

Es ist bekannt für die Herstellung von flexographischen Druckformen photopolymerisierbare Aufzeichnungselemente zu verwenden,bei denen die Druckoberfläche durch bildmässiges Belichten einer durch aktinische Strahlung photopolymerisierbaren Schicht und anschliessendes Entfernen der unbelichteten, nicht photopolymerisierten Bereiche erzeugt wird. Beispiele hierfür finden sich in den US Patenten in US 4,323,637; US 4,427,749 und US 4,894,315. Solche photopolymerisierbaren Aufzeichnungselemente setzen sich üblicherweise aus einem Schichträger, ggf. einer Haft- oder anderen Unterschichten, einer oder mehreren photopolymerisierbaren Schichten enthaltend mindestens ein polymeres Bindemittel, mindestens ein Monomer und mindestens einen Photoinitiator, ggf. einer elastomeren Zwischenschicht und einer Deckschicht zusammen.

Die bildmässige Belichtung der photopolymerisierbaren Aufzeichnungselemente erfolgt üblicherweise durch Auflegen einer Photovorlage, Entfernen der Luft mittels eines Vakuumrahmens und vollflächige Belichtung. Bei der Photovorlage handelt es sich um eine Maske, meist ein photographisches Negativ, mit für aktinische Strahlung opaken Bereichen und solchen, die für aktinische Strahlung durchlässig sind. Die durchlässigen Bereiche erlauben die Photopolymerisation der darunter liegenden Bereiche der photopolymerisierbaren Schicht bei Bestrahlung mit aktinischer Strahlung, und die opaken Bereiche der Maske verhindern die Photopolymerisation der darunter liegenden Bereiche der photopolymerisierbaren Schicht, so dass diese bei der Entwicklung entfernt werden können. Photovorlagen mit wachshaltigen Trenn- oder Gleitschichten sind aus der US 4,711,834 bekannt, und in der DE-C 39 41 493 sind Farbprüfdrucke mit Wachsschichten zwischen der farbgebenden Pigmentschicht und der bildmässig belichteten Schicht des Aufzeichnungsmaterials beschrieben.

Die genannten Photovorlagen weisen zahlreiche Nachteile auf, wie z.B. Temperatur- und Feuchtigkeitsempfindlichkeit oder auch umständliche und zeitaufwendige Korrekturmöglichkeiten. Es wurden daher digitale Verfahren und die dazugehörigen Materialien entwickelt, die kein photographisches Negativ benötigen. Solche Aufzeichnungsmaterialien umfassen ein übliches photopolymerisierbares Aufzeichnungselement wie im vorhergehenden beschrieben und zusätzlich eine integrierte Maske. Sie sind in WO 94/03838, WO 94/03839, WO 96/16356 und EP-A 0 767 407 beschrieben. Bei der integrierten Maske handelt es sich um eine IR-empfindliche Schicht, die für aktinische Strahlung undurchlässig ist. Diese IR-empfindliche Schicht wird digital bebildert, wobei das IR-empfindliche Material verdampft oder an einer darüberliegenden Folie fixiert wird. Durch anschliessende vollflächige Belichtung des photopolymerisierbaren Aufzeichnungselements durch die so hergestellte Maske, Auswaschen der nicht photopolymerisierten Bereiche und der verbliebenen Bereiche der IR-empfindlichen Schicht und Trocknen des Elements wird eine flexographische Druckform erhalten. Diese Aufzeichnungsmaterialien können ausserdem verschiedene Hilfsschichten zwischen der photopolymerisierbaren Schicht und der IR-empfindlichen Schicht enthalten.

Solche Aufzeichnungselemente des Standes der Technik weisen jedoch einige Nachteile auf. Zum einen ist die Haftung der IR-empfindlichen Schicht auf der photopolymerisierbaren Schicht oder ggf. dazwischenliegenden Hilfsschichten oft nicht ausreichend, so dass es zu falschem Ablösen der IR-empfindlichen Schicht kommt. Auch sind diese IR-Schichten extrem empfindlich und werden bei der Handhabung im Produktionsbetrieb sehr leicht mechanisch beschädigt.

Desweiteren ist es aus der US-A-5 534 383 bekannt, einen Farbprüfdruck herzustellen, wobei ein gewünschtes Bild von einer Bildübertragungsfolie auf eine weitere Folie übertragen wird. Das geschieht unter Verwendung eines Laminats aus beiden Folien, wobei auf der photopolymerisierbaren Schicht der Bildübertragungsfolie ein schmelzbares Material, z.B. eine Wachsschicht, in einem bestimmten Muster aufgebracht wird und die so erhaltene Folie dann in Kontakt gebracht wird mit der photopolymerisierbaren Schicht der zweiten Folie, auf die das Bild übertragen werden soll.

Der vorliegenden Erfindung lag daher die Aufgabe zugrunde, ein Verfahren zur Herstellung von flexographischen Druckformen zur Verfügung zu stellen, welches die beschriebenen Nachteile der Materialien des Standes der Technik nicht aufweist, ohne dass andere wesentliche Eigenschaften der photopolymerisierbaren Aufzeichnungselemente oder der daraus hergestellten flexographische Druckformen negativ beeinflusst werden.

Diese Aufgabe wurde gelöst durch ein Verfahren zur Herstellung von flexographischen Druckformen, wobei
a) die IR-empfindliche Schicht eines photopolymerisierbaren Aufzeichnungselements, umfassend einen Schichtträger, mindestens eine photopolymerisierbare Schicht enthaltend mindestens ein polymeres Bindemittel, mindestens eine ethylenisch ungesättigte, copolymerisierbare organische Verbindung und mindestens einen Photoinitiator oder ein Photoinitiatorsystem, und eine gegen IR-Strahlung empfindliche und gegenüber aktinischer Strahlung opake Schicht, wobei zwischen der photopolymerisierbaren Schicht und der IR-empfindlichen Schicht eine adhäsionvermittelnde Wachsschicht vorhanden ist mit einem IR-Laser bildmässig strukturiert wird, und so eine Maske erzeugt wird,
b) die photopolymerisierbare Schicht des photopolymerisierbaren Aufzeichnungselements durch vollflächige Belichtung mit aktinischer Strahlung durch die unter a) hergestellte Maske bildmässig photopolymerisiert wird und
c) die nicht photopolymerisierten Bereiche der photopolymerisierbaren Schicht, die verbliebenen Bereiche der IR-empfindlichen Schicht und die adhäsionsvermittelnde,

Wachsschicht durch ein oder mehrere Entwicklerlösemittel entfernt werden.

Überraschenderweise wird durch die Wachsschicht die Adhäsion der IR-empfindlichen Schicht zur photopolymerisierbaren Schicht erhöht. Dies war um so erstaunlicher als Wachse üblicherweise als Trenn- oder Gleitmittel verwendet werden, wie dies auch in der DE-C 39 41 493 für Farbprüfdrucke und in der US 4,711,834 für übliche Photovorlagen beschrieben ist. Ein weiterer Vorteil der vorliegenden Erfindung ist, dass durch die zusätzliche Wachsschicht die mechanische Empfindlichkeit der IR-empfindlichen Schicht weitgehend eliminiert werden kann. Ausserdem wird bei der Laserbelichtung ca. 15% weniger Energie benötigt als bei der Verwendung von IR-Schichten ohne Wachsschicht.

Die Dicke der Wachsschicht beträgt 0,02 - 1,0 µm, bevorzugt 0,05 - 0,5 µm. Geeignete Wachse sind alle natürlichen und synthetischen Wachse, insbesondere Polyolefinwachse, Paraffinwachse, Carnaubawachse, Montanwachse, Stearin- und/oder Steramidwachse. Bevorzugt werden Wachse mit einer Erweichungstemperatur ≥ 70 °C, bevorzugt 80 - 160 °C, besonders bevorzugt 90 - 150 °C, verwendet. Insbesondere Polyethylenwachse mit einer Erweichungstemperatur oberhalb 90 °C eigenen sich für die Herstellung der Adhäsionsschichten.

Die Wachsschicht kann durch übliche Verfahren, wie z.B. Vergiessen, Verdrucken, oder Versprühen von Dispersionen in geeigneten Lösemitteln und anschliessende Trocknung hergestellt werden. Zusätze wie Netzmittel, Giesshilfsmittel, etc. können verwendet werden. Bevorzugt wird die Wachsschicht im Tiefdruckverfahren entweder auf die IR-empfindliche Schicht oder auf das photopolymerisierbare Aufzeichnungselement aufgebracht. Insbesondere die Aufbringung auf die IR-empfindliche Schicht ist bevorzugt.

Bei der IR-empfindlichen Schicht handelt es sich bevorzugt um eine im Entwickler lösliche oder dispergierbare Schicht, die gegenüber UV- bzw. sichtbarem Licht opak ist, d.h. eine optische Dichte von ≥ 2,5 aufweist, und mittels IR-Laser bebilderbar ist. Diese Schicht enthält ein IR-absorbierendes Material mit einer hohen Absorption im Wellenlängenbereich zwischen 750 und 20 000 nm, wie z.B. polysubstituierte Phthalocyaninverbindungen, Cyaninfarbstoffe, Merocyaninfarbstoffe, etc. oder anorganische Pigmente wie z.B. Russ, Graphit, Chromoxide, etc. oder Metalle wie Aluminium, Kupfer, etc. Die Menge des IR-absorbierenden Materials beträgt üblicherweise 0,1 - 40 Gew.-% bezogen auf das Gesamtgewicht der Schicht. Um die optische Dichte von ≥ 2,5 gegenüber der aktinischen Strahlung zu erhalten enthält die IR-empfindliche Schicht ein die Transmission der aktinischen Strahlung verhinderndes Material, wie z.B. Farbstoffe oder Pigmente, insbesondere die o.g. anorganischen Pigmente. Die Menge dieses Materials beträgt üblicherweise 1 - 70 Gew.-% bezogen auf das Gesamtgewicht der Schicht. Ggf. enthält diese Schicht ein polymeres Bindemittel, wie z.B. Nitrocellulose, Homo- oder Copolymere von Acrylaten, Methacrylaten und Styrolen, Polyamide, Polyvinylalkohole, etc. Weitere Hilfsmittel wie Weichmacher, Giesshilfsmittel, etc. sind möglich. Die IR-empfindliche Schicht wird üblicherweise durch Giessen oder Drucken einer Lösung bzw. Dispersion der o.g. Bestandteile auf eine abziehbare Deckschicht, z.B. aus Polyethylen oder Polyethylenterephthalat, und anschliessende Trocknung hergestellt. Die Dicke der IR-empfindlichen Schicht beträgtüblicherweise 2 nm bis 50 µm, bevorzugt 4 nm bis 40 µm. Diese IR-empfindlichen Schichten und ihre Herstellung sind z.B. im Detail in der WO 94/03838 und der WO 94/3839 beschrieben.

Das so erhaltene Deckelement aus einer abziehbaren Deckfolie, einer IR-empfindlichen Schicht und einer Adhäsionschicht wird dann so mit einer photopolymerisierbaren Schicht in Verbindung gebracht, dass die Adhäsionschicht in Kontakt mit der photopolymerisierbaren Schicht ist. Dies kann durch Lamination des genannten Deckelements auf ein photopolymerisierbares Aufzeichnungselement, umfassend einen Schichtträger, mindestens eine photopolymerisierbare Schicht und ggf. Hilfsschichten, wie z.B. einer Haftschicht zwischen der photopolymerisierbaren Schicht und dem Schichträger oder einer Sperrschicht auf der zur Wachsschicht gewandten Oberfläche der photopolymerisierbaren Schicht, erfolgen oder die photopolymerisierbare Schicht wird direkt zwischen das o.g. Deckelement und den Schichtträger, mit oder ohne Hilfsschichten, extrudiert.

Als photopolymerisierbare Schichten eignen sich alle bekannten, üblicherweise ein elastomeres Bindemittel, ein Monomer und einen Photoinitiator enthaltenden, Materialien. Als elastomere Bindemittel eignen sich beispielweise Polyalkandiene, Alkadien/Acrylnitril- Copolymere, Ethylen/Propylen/Alkadien-Copolymere,Etylen/(Meth)Acrylsäure/(Meth)Acrylat-Copolymere und thermoplastisch elastomere Blockcopolymere aus Styrol und Butadien oder Isopren. Bevorzugt werden lineare und radiale thermoplastisch elastomere Blockcopolymere aus Styrol und Butadien oder Isopren verwendet. Die Menge des Bindemittels beträgt bevorzugt mindestens 65 Gew.-% bezogen auf das Gesamtgewicht der Schicht. Als Monomere können übliche etylenisch ungesättigte, copolymerisierbare organische Verbindungen, wie z.B. Acrylate und Methacrylate von ein- oder mehrwertigen Alkoholen, (Meth)acrylamide, Vinylether und -ester, etc., insbesondere Acryl- und/oder Methacrylester von Butandiol, Hexandiol, Diethylenglykol, Trimethylolpropan, Pentaerythrit, etc. und Gemische solcher Verbindungen verwendet werden. Die Menge der Monomeren beträgt bevorzugt mindestens 5 Gew.-% bezogen auf das Gesamtgewicht der Schicht. Als Photinitiatoren können einzelne Photoinitiatoren oder auch Photoinitiatorsysteme verwendet werden, wie z.B. Benzoinderivate, Benzilacetale, Diarylphosphinoxide, etc. auch im Gemisch mit Triphenylphosphin, tertiären Aminen, etc. Die Menge der Photoinitiatoren beträgt üblicherweise 0,001 - 10 Gew.-% bezogen auf das Gesamtgewicht der Schicht. Ggf. enthalten die photopolymerisierbaren Materialien noch Hilfsstoffe wie z.B. Inhibitoren, Weichmacher, Farbstoffe, Giesshilfsmitte, etc. Die Dicke der photopolymerisierbaren Schicht beträgt für die sogenannten "dünnen Platten" 0,05 - 0,13 cm und für dickere Platten 0,25 - 0,64 cm. Es können eine oder mehrere dieser Schichten verwendet werden. Die Herstellung der verwendeten photopolymerisierbaren Schichten erfolgt durch Mischen der Bestandteile und Verarbeitung der Mischungen mit Hilfe üblicher Techniken wie z.B. Giessen, Kalandrieren, Extrudieren, etc. Übliche photopolymerisierbare Materialien und deren Herstellung sind dem Fachmann bekannt. Besonders bevorzugte photopolymerisierbare Materialien und ihre Herstellung und Verarbeitung sind beispielsweise in US 4,323,637; US 4,427,749 und US 4,894,315 beschrieben.

Die Verarbeitungsschritte eines Aufzeichnungselements, die die bildmässige Belichtung mit einem IR-Laser, die vollflächige Belichtung mit aktinischer Strahlung, die Entwicklung, die Trocknung und die Nachbehandlung umfassen, sind der WO 94/03838 bzw. der WO 94/3839 ausführlich beschrieben.

Zuerst wird, ggf. nach der Entfernung der abziehbaren Deckschicht, die IR-empfindliche Schicht mit einem beliebigen IR-Laser, z.B. einem Diodenlaser mit einer Emisssion zwischen 750 und 880 nm, bevorzugt 780 und 850 nm, oder einem YAG-Laser mit einer Emission bei 1060 nm, bildmässig beschrieben. Hierbei wird die IR-empfindliche Schicht verdampft oder an der darüberliegenden Deckfolie fixiert und mit dieser abgezogen.

Die vollflächige Belichtung des photopolymerisierbaren Aufzeichnungselements erfolgt mit üblichen Strahlungsquellen, wie z.B. Xenonlampen, Kohlebogenlampen, Quecksilberdampflampen, Fluoreszenslampen mit UV-Strahlung emittierenden Leuchtstoffen, etc. Vor oder nach der Laserbelichtung bzw. vor oder nach der vollflächigen Belichtung kann eine Rückseitenbelichtung durchgeführt werden. Diese kann diffus oder gerichtet mit den o.g. Lichtquellen erfolgen.

Das Auswaschen der nicht photopolymerisierten Bereiche kann je nach verwendetem Bindemittelsystem mit Wasser, wässrigen oder halb-wässrigen Lösungen oder geeigneten organischen Entwicklerlösemitteln, wie z.B. aliphatischen oder aromatischen Kohlenwaserstoffen wie n-Hexan, Petrolether, hydrierte Erdölfraktionen, Limonen oder anderen Terpenen oder Toluol, Isopropylbenzol, etc., Ketonen wie z.B. Methylethylketon, halogenierten Kohlenwasserstoffen wie Chloroform, Trichlorethan oder Tetrachlorethylen, Estern wie z.B. Essigsäure oder Acetessigsäureester oder Gemischen der genannten Lösemitteln, durchgeführt werden. Zusätze wie Tenside oder Alkohole sind möglich. Hierbei werden die nicht photopolymerisierten Bereiche der photopolymerisierbaren Aufzeichnungsschicht, die verbliebenen Bereiche der IR-empfindlichen Schicht, die Adhäsionsschicht und eine ggf. vorhandene Sperrschicht entfernt.

Nach dem Trocknen können die so erhaltenen Druckformen zur Herstellung einer klebfreien Druckoberfläche in beliebiger Reihenfolge nachbelichtet und/oder chemisch bzw. physikalisch nachbehandelt werden.

Die folgenden Beispiele sollen die vorliegende Erfindung verdeutlichen. Die angegebenen Teile und Prozente beziehen sich, falls nichts anderes angegeben ist, auf das Gewicht.

### Beispiele:

Eine 1:2-Mischung aus Kohlenstoff-Ruß (Printex® 300 der Firma Degussa) und einem Polyamid-Bindemittel mit einem Erweichungspunkt von 140 °C (Macromelt® 6900 der Firma Henkel) in Toluol/i-Propanol (1:1) wurde im Tiefdruckverfahren auf eine Polyesterunterlage (75 µm) in einer Schichtstärke von 2.5 g/m² aufgebracht. Nach dem Trocknen wurden auf Probestreifen der so hergestellten Rußschicht verschiedene Wachsdispersionen (Tabelle 1) mit einem Handrakel (50 µm) aufgebracht und bei Raumtemperatur getrocknet. Nach dem Trocknen hatten die Wachsschichten die in Tabelle 1 angegebenen Schichtdicken. Wachs 5 wurde im Tiefdruckverfahren aufgebracht. Diese wachsbeschichteten Rußschichten wurden dann bei 100°C- 160°C so auf eine Photopolymerdruckplatte (CYREL® HCS der Firma DuPont deren Druckschicht vorher entfernt worden war) in einem Cromalin® White Line Laminator der Firma DuPont auflaminiert, daß die Wachsschicht zum Photopolymer gerichtet war. Zum Vergleich wurde eine Polyamid/Rußschicht, die keine Wachsschicht besass, unter gleichen Bedingungen auflaminiert. Anschließend wurde die Polyesterdeckschicht von der Rußschicht mit der Hand abgezogen. Dabei muß die Rußschicht vollständig auf der Photopolymerplatte haften bleiben. Die Ergebnisse sind in Tabelle 2 zusammengefasst.

**Tabelle 1**

| Wachsansätze | Konzentration Gew. -% | Lösemittel | Schichtdicke (µm) |
|---|---|---|---|
| Wachs 1 | 0,05 | Isopropanol | 0,03 |
| Wachs 2 | 0,2 | Isopropanol | 0,1 |
| Wachs 3 | 0,1 | Dipropylenglykolether | 0,05 |
| Wachs 4 | 0,1 | Isopropanol | 0,05 |
| Wachs 5 | 0,1 | Butoxyethanol/Wasser (1:1) | 0,05 |

**Tabelle 2**

| | Wachse | Erweichungstemp. [°C] | Teilchengrösse [µm] | Haftung zum Photopolymer |
|---|---|---|---|---|
| 1. | Polyolefinwachs | 93-99 | 3-6 | keine Delamination |
| 2. | Paraffinwachs | 90-93 | 10-15 | keine Delamination |
| 3. | Carnaubawachs | 82-86 | 1-3 | keine Delamination |
| 4. | Carnaubawachs | 82-86 | 2-4 | keine Delamination |
| 5. | Polyethylenwachs | 138-143 | 15-20 | keine Delamination |
| 6. | Rußschicht ohne Wachs | | | teilweise Delamination |

### Druckversuch:

In einem Maschinenversuch wurde eine Rußschicht wie oben beschrieben hergestellt (auf 75µm Polyester), mit dem Wachs aus Versuch 5 wie oben beschrieben beschichtet und auf eine Photopolymerdruckplatte (CYREL® DUV 45 der Firma DuPont) bei ca. 160°C wie oben beschrieben auflaminiert. Danach wurde die Polyesterschutzschicht von der Rußschicht entfernt und in einem Cyrel® CDI Laser Imager der Firma DuPont (14 Watt) wurden selektiv bildmäßige Strukturen aus der Rußschicht herausgebrannt. Die verbleibenden bildmäßigen Restflächen der Rußschicht dienten als Photomaske bei der anschließenden Belichtung der Platte mit aktinischem Licht in einem Cyrel® 1001 E Belichtungsgerät der Firma DuPont. Nach der Belichtung wurden die durch die Rußschicht geschützten (unbelichteten) Teile der photopolymerisierbaren Schicht (zusammen mit den verbliebenen Bereichen der Rußschicht und der Wachsschicht) in einem Entwicklungsgerät Cyrel® 2001 P der Firma DuPont mit Optisol® der Firma DuPont als Entwicklerlösemittel herausgewaschen. Mit der so hergestellten Flexodruckform wurden Druckversuche auf Papier und Polypropylenfolie durchgeführt. Die erhaltenen Druckergebnisse zeigten im Vergleich zu Standarddruckformen keine Nachteile oder Defekte. Darüberhinaus zeigten die Versuche, daß bei der Laserbelichtung ca. 15% weniger Energie benötigt wurde als bei Verwendung von Rußschichten ohne Wachs.

## Patentansprüche

1. Verfahren zur Herstellung von flexographischen Druckformen, wobei
a) die IR-empfindliche Schicht eines photopolymerisierbaren Aufzeichnungselements umfassend einen Schichtträger, mindestens eine photopolymerisierbare Schicht, enthaltend mindestens ein polymeres Bindemittel, mindestens eine ethylenisch ungesättigte, copolymerisierbare organische Verbindung und mindestens einen Photoinitiator oder ein Photoinitiatorsystem, und eine gegen IR-Strahlung empfindliche und gegenüber aktinischer Strahlung opake Schicht, wobei zwischen der photopolymerisierbaren Schicht und der IR-empfindlichen Schicht eine adhäsionvermittelnde Wachsschicht vorhanden ist mit einem IR-Laser bildmässig strukturiert wird, und so eine Maske erzeugt wird,
b) die photopolymerisierbare Schicht des photopolymerisierbaren Aufzeichnungselements durch vollflächige Belichtung mit aktinischer Strahlung durch die unter a) hergestellte Maske bildmässig photopolymerisiert wird und
c) die nicht photopolymerisierten Bereiche der photopolymerisierbaren Schicht, die verbliebenen Bereiche der IR-empfindlichen Schicht und die adhäsionsvermittelnde Wachsschicht durch ein oder mehrere Entwicklerlösemittel entfernt werden.

2. Verfahren nach Anspruch 1
**dadurch gekennzeichnet, dass**
die Dicke der Wachsschicht 0,02 - 1,0 µm beträgt.

3. Verfahren nach einem der Ansprüche 1 oder 2
**dadurch gekennzeichnet, dass**
die Dicke der Wachsschicht 0,05 - 0,5 µm beträgt.

4. Verfahren nach einem der Ansprüche 1 bis 3
**dadurch gekennzeichnet, dass**
als Wachse Polyolefinwachse, Paraffinwachse, Carnaubawachse, Montanwachse, Stearin- und/oder Steramidwachse verwendet werden.

5. Verfahren nach einem der Ansprüche 1 bis 4
**dadurch gekennzeichnet, dass**
die IR-empfindliche Schicht durch IR-Laserbestrahlung entfernbar ist.

6. Verfahren nach einem der Ansprüche 1 bis 5
**dadurch gekennzeichnet, dass**
die IR-empfindliche Schicht Russ enthält.

7. Verfahren nach einem der Ansprüche 1 bis 6
**dadurch gekennzeichnet, dass**
zwischen dem Schichtträger und der photopolymerisierbaren Schicht eine Haftschicht vorhanden ist.

8. Verfahren nach einem der Ansprüche 1 bis 7
**dadurch gekennzeichnet, dass**
zwischen der photopolymerisierbaren Schicht und der Wachsschicht eine Sperrschicht vorhanden ist.

9. Verfahren nach einem der Ansprüche 1 bis 8
**dadurch gekennzeichnet, dass**
auf der der Wachsschicht abgewandten Oberfläche der IR-empfindlichen Schicht eine abziehbare Deckschicht vorhanden ist.

10. Verfahren nach Anspruch 9, **dadurch gekennzeichnet, dass** die abziehbare Deckschicht vor der IR-Laserbestrahlung oder nach der IR-Laserbestrahlung aber vor der vollflächigen Belichtung entfernt wird.

## Claims

1. A method of producing flexographic printing forms, in which
a) the IR-sensitive layer of a photopolymerisable recording element, comprising a layer support, at least one photopolymerisable layer, containing at least one polymeric binder, at least one ethylenically unsaturated, copolymerisable organic compound and at least one photoinitiator or photoinitiator system, and a layer sensitive to IR radiation and opaque to actinic radiation, an adhesion-promoting wax layer being present between the photopolymerisable layer and the IR-sensitive layer, is structured imagewise with an IR laser, and a mask is thereby produced,
b) the photopolymerisable layer of the photopolymerisable recording element is photopolymerised imagewise by all-over exposure with actinic radiation through the mask produced under a) and
c) the non-photopolymerisable areas of the photopolymerisable layer, the remaining areas of the IR-sensitive layer and the adhesion-promoting wax layer are removed by one or more developer solvent(s).

2. A method according to claim 1, **characterised in that** the thickness of the wax layer amounts to 0.02 to 1.0 µm.

3. A method according to one of claims 1 or 2, **characterised in that** the thickness of the wax layer amounts to 0.05 to 0.5 µm.

4. A method according to one of claims 1 to 3, **characterised in that** polyolefin wax, paraffin wax, carnauba wax, montan wax, stearin wax and/or stearamide wax are used as wax.

5. A method according to one of claims 1 to 4, **characterised in that** the IR-sensitive layer may be removed by IR laser irradiation.

6. A method according to one of claims 1 to 5, **characterised in that** the IR-sensitive layer contains carbon black.

7. A method according to one of claims 1 to 6, **characterised in that** an adhesion layer is present between the layer support and the photopolymerisable layer.

8. A method according to one of claims 1 to 7, **characterised in that** a barrier layer is present between the photopolymerisable layer and the wax layer.

9. A method according to one of claims 1 to 8, **characterised in that** a peel-off top layer is present on the surface of the IR-sensitive layer remote from the wax layer.

10. A method according to claim 9, **characterised in that** the peel-off top layer is removed prior to the IR laser irradiation or after the IR laser irradiation but prior to the all-over exposure.

## Revendications

1. Procédé de fabrication de plaques d'impression flexographiques,
dans lequel
a) la couche sensible aux infrarouges d'un élément d'enregistrement photopolymérisable qui comprend un support de couche, au moins une couche photopolymérisable contenant au moins un liant polymère, au moins un composé organique copolymérisable non saturé éthyléniquement et au moins un photo-initiateur ou un système de photo-initiateurs, et une couche sensible au rayonnement IR et opaque au rayonnement actinique, une couche de cire procurant une adhérence étant présente entre la couche photopolymérisable et la couche sensible aux infrarouges, est structurée selon une image au moyen d'un laser IR, un masque étant ainsi produit,
b) la couche photopolymérisable de l'élément d'enregistrement photopolymérisable est photopolymérisée selon une image à travers le masque fabriqué selon le point a) par une exposition de toute sa surface à un rayonnement actinique et
c) les zones non photopolymérisées de la couche photopolymérisable, les zones restantes de la couche sensibles aux infrarouges et la couche de cire procurant une adhérence sont éliminées par un ou plusieurs solvant/s développeur/s.

2. Procédé selon la revendication 1, **caractérisé par le fait que** la couche de cire mesure entre 0,02 et 1,0 µm d'épaisseur.

3. Procédé selon une des revendications 1 ou 2, **caractérisé par le fait que** la couche de cire mesure entre 0,05 et 0,5 µm d'épaisseur.

4. Procédé selon une des revendications 1 à 3, **caractérisé par le fait que** l'on utilise, en tant que cire, de la cire de polyoléfine, de la cire de paraffine, de la cire de carnauba, de la cire de lignite, de la cire de stéarine et/ou de stéaramide.

5. Procédé selon une des revendications 1 à 4, **caractérisé par le fait que** la couche sensible aux infrarouges peut être éliminée par un rayonnement laser infrarouge.

6. Procédé selon une des revendications 1 à 5, **caractérisé par le fait que** la couche sensible aux infrarouges contient du noir de carbone.

7. Procédé selon une des revendications 1 à 6, **caractérisé par le fait qu'**une couche adhésive est présente entre le support de couche et la couche photopolymérisable.

8. Procédé selon une des revendications 1 à 7, **caractérisé par le fait qu'**une couche de blocage est présente entre la couche photopolymérisable et la couche de cire.

9. Procédé selon une des revendications 1 à 8, **caractérisé par le fait qu'**une couche de recouvrement pelable est présente sur la surface de la couche sensible aux infrarouges éloignée de la couche de cire.

10. Procédé selon la revendication 9, **caractérisé par le fait que** la couche de recouvrement pelable est enlevée avant le rayonnement laser infrarouge ou après le rayonnement laser infrarouge, mais avant l'exposition de toute la surface.
